# EUROPEAN PATENT APPLICATION

(11) **EP 2 086 034 A1**
(43) Date of publication of application: **05.08.2009**
(21) Application number: 08150983.8
(22) Date of filing: 01.02.2008
(51) Int. Cl.: H01L 51/52

(54) **Electronic device and method of manufacturing thereof**

(71) Applicant: Nederlandse Centrale Organisatie Voor Toegepast Natuurwetenschappelijk Onderzoek TNO, 2628 VK Delft (NL)
(72) Inventor: de Vries, Ike, 5171 WV Kaatsheuvel (NL); van den Brand, Jeroen, 5053 AT Goirle (NL); Kruijt, Peter G.M., 5641 HE Eindhoven (NL)
(74) Representative: Hatzmann, Martin

(57) **Abstract**

A method of manufacturing an electronic device is disclosed comprising a sequence of functional layers. The method comprises the steps of
- providing a substrate
- providing a patterned first functional layer of a first substance on the substrate, resulting in at least one first area covered by the first substance having a surface tension or surface energy SUn and at least one second area not covered by the first substance having a surface tension or surface energy SUm,
- applying a second functional layer as a liquid substance, the liquid substance having a surface tension STk in the range of SUm < STk ≤ SUn.

## Description

### BACKGROUND OF THE INVENTION

### Field of the invention

The present invention relates to an electronic product.

The present invention further relates to a method of manufacturing thereof

### Related Art

Electronic products are commonly manufactured by applying a sequence of functional layers on a substrate. For example an OLED is usually built from a stack comprising an anode of a conducting material, a hole transporting layer, a light emitting layer, and a cathode. Preferably the OLED is embedded within barrier layers. Other electronic devices using such a layered structure such as solar cells are known.

In mass production a plurality of such electronic devices are constructed on a substrate and after construction separated from each other for further processing into the end product. A plurality of such electronic devices may be constructed by patterning the subsequent layers. It is important that elements formed by these functional layers are applied with sufficient accuracy, so that they are positioned correctly with respect to one another and are capable of proper mutual cooperation.

Known methods to form patterned functional layers use printing process techniques like gravure of flexo printing. These printing techniques have the drawback that there is contact between the substrate and the printer rollers. If the substrate has a certain topology e.g. formed by the presence of metal pads, this will lead to thickness in-homogeneity of the coating.

According to another known method first a complete layer is applied to a substrate. Subsequently the layer is patterned via laser ablation. This method, however, has the drawback that the device to be manufactured is contaminated by debris during the ablation process. This will result in defects and malfunction.

Other methods are known based on the principle of differential wetting. Such methods rely on the phenomenon that liquids applied on a surface spontaneously move from lhydrophobic areas of the surface to hydrophilic areas. In this way the applied liquid rearranges itself into a shape corresponding to the pattern of hydrophobic and hydrophilic areas.

Patent US2007/0020395 describes a process in which hydrophobic and hydrophilic patches are applied to a substrate. According to this known patterning process, however, the patterning method is based upon partial removing of the hole injection layer (PEDOT:PSS or fluorinated buffer material). In this way de-wetting of the luminescent layer (LEP layer) on the hole injection layer is prevented.

### SUMMARY OF THE INVENTION

It is a purpose of the present invention to provide a method of manufacturing based on differential wetting that does not require partial removal.

It is a further purpose of the present invention to provide an improved electronic product.

According to a first aspect of the invention a method as claimed in claim 1 is provided. According to this method a second functional layer is applied as a liquid substance, the liquid substance having a surface tension STk in the range of SUm < STk ≤ SUn, wherein SUn is a surface tension or surface energy of a first substance used for a first functional layer and SUm is a surface tension or surface energy for areas not covered by the first substance. The term surface energy is associated with solids, while the term surface tension is associated with liquids. The dimension of these terms is however the same, namely expressed in mN/m.

By carefully selecting the surface tension of the liquid substance it is possible that the second functional layer fully wets the first functional layer and withdraws from the remaining areas. In this way it is possible to use an already present functional layer to control the patterning of the subsequent layer. This results in an accurate adaptation of the pattern of the second functional layer to the pattern formed by the first functional layer. A functional layer is defined as a layer that remains in the manufactured device without which the device would not function, or would function substantially worse or would have a substantially shorter lifetime, such as a cathode layer, a luminescent layer, a hole transporting layer, a hole injection layer, an electron transport layer or an electron injection layer.

An embodiment of this method is characterized by the additional step of drying the first functional layer before the second functional layer is applied. This embodiment is preferred in case that the liquid substance uses a substantially different basis than the substance used for the first functional layer. For example the liquid substance used for the second functional layer is water-based, while the first substance is solvent based (e.g methylbenzoate, mesithylene, xylene, dichlorobenzene, chlorobenzene tetrahydro naphthalene). In this case the first functional layer obtains a surface energy SE3 after it is dried. The surface energy of the dried first functional layer is determined by the selection of organic polymers which may include additives like surfactants for the first substance.

An alternative embodiment is characterized in that the second functional layer is applied before the first functional layer is dried. As long as the difference in surface tension between the substance of the first functional layer and the surface tension of the second functional layer is not too high and the substance used for the first functional layer has a sufficiently high viscosity the processing speed can be increased in this way. This embodiment of the invention saves an additional processing step. This embodiment is in particular suitable for applying a sequence of layers having a gradually changing property. For example in an OLED a plurality of luminescent layers may be constructed upon each other, wherein each subsequent luminescent layer has an influence on the efficiency of the OLED device.

In a very attractive version of this embodiment a least a third functional layer is applied simultaneously with the second functional layer at the first functional layer. A known technology to apply a plurality of layers simultaneously is cascaded curtain coating. Application of this technology to provide patterned functional layers is not known however.

In a preferred embodiment the first substance is an electrically conductive material that forms hydrophilic areas with a surface energy SUn, while the remaining area is hydrophobic with a surface energy SUm and the second functional layer is applied as a solution having a surface tension ST in a range SUm < ST < SUn. In electronic devices often the first functional layer is an electrically conductive layer, e.g. a cathode or an anode. By selecting a substance for the first functional layer having a surface energy SUn substantially higher than the surface energy SUm of the substrate, the second layer forms a pattern conforming to the pattern of this electrically conductive layer, provided that the surface tension of the solution used for the second functional layer is in the range between SUm and SUn. Likewise subsequent functional layers may be applied on the second functional layer that follows the pattern of the second functional layer.

In mass fabrication a plurality of stacks of functional layers may be formed using a method according to the invention. In an embodiment of the method a stack of functional layers formed upon said at least one area is separated from a remaining portion of a semi-finished product using the previous steps, to obtain a separate semi-finished product. The separate semi-finished product may then be integrated in a package. Before integration the substrate may be removed from said stack of functional layers after the step of separating. This may be facilitated by a release layer.

According to a further aspect of the invention an electronic device is provided as claimed in claim 8. In this electronic device the second functional layer has a thickness D that covers the first functional layer. The second functional layer covers the side surfaces of the first functional layer, the second functional layer being bounded laterally at a distance of at most 2D from the side surfaces of the first functional layer. In the electronic device according to the invention the second functional layer, e.g. a LEP layer or photovoltaic layer encapsulates a first functional layer, e.g. a hole transport layer, such as a PEDOT:PSS layer. By this encapsulation shortcuts between the first functional layer and subsequent layers (e.g. a cathode) upon the second layer are prevented. When the second functional layer is bounded laterally at a distance substantially more than 2D, e.g. 3D, this would however result in a loss of material and an efficiency loss, because part of the device, in the area outside the area formed by the first functional layer is not functional. Such an electronic device is obtained preferably by a method according to the invention. When the method according to the invention is applied, the solution for applying the second functional layer fully wets the patterns formed in the first functional layer so that these patterns become encapsulated. Additionally the environment of the first functional layer repels the solution, so that the lateral distance at which the second functional layer is bounded in practice is less than 2D.

The electronic device is for example an OLED, a solar cell or an OFET.

### BRIEF DESCRIPTION OF THE DRAWINGS

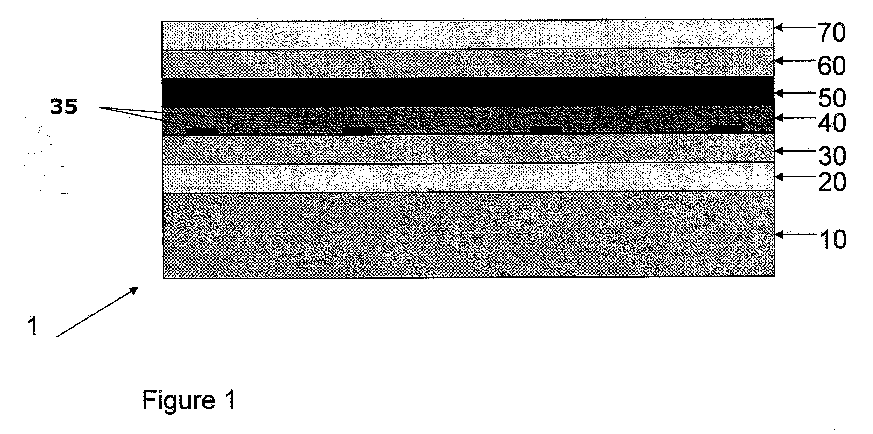

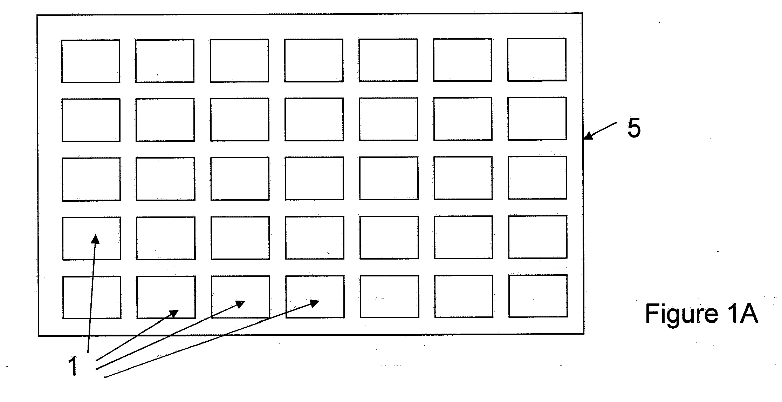

These and other aspects are described with reference to the drawing. Therein Figure 1 shows a first product according to the invention,
Figure 1A shows a semi-finished product used in mass fabrication,
Figure 2A-2C shows steps in a first embodiment of a method according to the invention,
Figure 3 shows a step in a second embodiment of a method according to the invention,
Figures 4A, 4B illustrates devices for use with an embodiment of a method according to the invention,
Figure 5 shows a second product that can be manufactured using a method according to the present invention.

### DETAILED DESCRIPTION OF EMBODIMENTS

In the following detailed description numerous specific details are set forth in order to provide a thorough understanding of the present invention. However, it will be understood by one skilled in the art that the present invention may be practiced without these specific details. In other instances, well known methods, procedures, and components have not been described in detail so as not to obscure aspects of the present invention. In the drawings, the size and relative sizes of layers and regions may be exaggerated for clarity. Embodiments of the invention are described herein with reference to cross-section illustrations that are schematic illustrations of idealized embodiments (and intermediate structures) of the invention. As such, variations from the shapes of the illustrations as a result, for example, of manufacturing techniques and/or tolerances, are to be expected. Thus, embodiments of the invention should not be constructed as limited to the particular shapes of regions illustrated herein but are to include deviations in shapes that result, for example, from manufacturing.

It will be understood that when an element or layer is referred to as being "on", "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numbers refer to like elements throughout. As used herein, the term "and/or" includes any and all combinations of one or more of the associated listed items.

It will be understood that, although the terms first, second, third etc. may be used herein to describe various elements, components, regions, layers and/or sections, these elements, components, regions, layers and/or sections should not be limited by these terms. These terms are only used to distinguish one element, component, region, layer or section from another region, layer or section. Thus, a first element, component, region, layer or section discussed below could be termed a second element, component, region, layer or section without departing from the teachings of the present invention.

By way of example application of a method according of the invention for manufacturing an OLED device is described. A practical embodiment of an OLED is shown in Figure 1.

An OLED 1 is usually built from a stack comprising an anode 40 of a conducting material, a hole transporting layer 40, a light emitting layer 50, and a cathode 60. Preferably the OILED is embedded within barrier layers 20, 70 and arranged on a substrate 10. Furthermore busbars 35 may be present to electrically couple the device to external conductors.

The substrate 10 is preferably from a resin or metal base material, for example in the form of a foil having a thickness in the range of 100-200µm. Such resin base materials preferably include polyethylene terephthalate (PET), polyethylene naphthalate (PEN), polyimide (PI), polyetherimide (PEI), polyethersulfone (PES), polysulfone (PSF), polyphenylene sulfide (PPS), polyether ether ketone (PEEK), polyarylate (PAR), polyamide-imide (PAI); stainless steel and aluminum. Other resin materials include polycycloolefin resin, acrylic resin, polystyrene, ABS, polyethylene, polypropylene, polyamide resin, polyvinyl chloride resin, polycarbonate resin, polyphenyleneether resin and cellulose resin, etc.

The conductive material used for the anode 30 is preferably a transparent electrically conductive material such as polyaniline, polythiophene, polypyrrole or doped polymers. Apart from organic materials, various inorganic transparent, electrically conducting materials are available like ITO (Indium Tin Oxide), IZO (Indium Zinc Oxide), ATO (Antimony Tin Oxide), or Tin Oxide can be used. Other metal oxides can work, including but not limited to Nickel-Tungsten-Oxide, Zinc Oxide, Magnesium-Indium-Oxide. In an embodiment the anode is a layer with a thickness of 10-500 nm, preferably 50-200 nm, for example 100 nm.

Examples of hole transport materials for the hole transport layer 40 have been summarized for example, in Kirk-Othmer Encyclopedia of Chemical Technology, Fourth Edition, Vol. 18, p. 837-860, 1996, by Y. Wang. Both hole transporting molecules and polymers can be used. Commonly used hole transporting molecules include, but are not limited to: 4,4',4"-tris(N,N-diphenyl-amino)-triphenylamine (TDATA); 4,4',4"-tris(N-3-methylphenyl-N-phenyl-amino)-triphenylamine (MTDATA); N,N'-diphenyl-N,N'-bis(3-methylphenyl)'-[1,1'-biphenyl]-4,4'-diamine (TPD); 1,1-bis[(di-4-tolylamino)phenyl]cyclohexane (TAPC); N,N'-bis(4-methylphenyl)-N,N'-bis(4-ethylphenyl)-[1,1'-(3,3'-dimethyl)biphenyl]-4,4'-diamine (ETPD); tetrakis-(3-methylphenyl)-N,N,N',N'-2,5-phenylenediamine (PDA); a-phenyl-4-N,N-diphenylaminostyrene (TPS); p-(diethylamino)benzaldehyde diphenylhydrazone (DEH); triphenylamine (TPA); bis[4-(N,N-diethylamino)-2-methylphenyl](4-methylphenyl)methane (MPMP); 1-phenyl-3-[p-(diethylamino)styryl]-5-[p-(diethylamino)phenyl]pyrazoline (PPR or DEASP); 1,2-trans-bis(9H-carbazol-9-yl)cyclobutane (DCZB); N,N,N',N'-tetrakis(4-methylphenyl)-(1, 1'-biphenyl)-4,4'-diamine (TTB); N,N'-bis(naphthalen-1-yl)-N,N'-bis-(phenyl)benzidine (α-NPB); and porphyrinic compounds, such as copper phthalocyanine. Commonly used hole transporting polymers include, but are not limited to, poly(9,9,-dioctyl-fluorene-co-N-(4-butylphenyl)diphenylamine), and the like, polyvinylcarbazole, (phenylmethyl)polysilane, poly(dioxythiophenes), polyanilines, and polypyrroles. It is also possible to obtain hole transporting polymers by doping hole transporting molecules such as those mentioned above into polymers such as polystyrene and polycarbonate. The hole transporting layer may have a thickness in the range of 50-200 nm. In the embodiment shown a PEDOT:PSS-layer having a thickness of 100 nm is applied.

The light-emitting layer 50 may typically be any organic electroluminescent ("EL") material, including, but not limited to, small molecule organic fluorescent compounds, fluorescent and phosphorescent metal complexes, conjugated polymers, and combinations or mixtures thereof. Examples of fluorescent compounds include, but are not limited to, pyrene, perylene, rubrene, dcm, coumarin, derivatives thereof, and mixtures thereof. Examples of metal complexes include, but are not limited to, metal chelated oxinoid compounds, such as tris(8-hydroxyquinolato)aluminum (Alq3); cyclometalated iridium and platinum electroluminescent compounds, such as complexes of iridium with phenylpyridine, phenylquinoline, or phenylpyrimidine ligands as disclosed in Petrov et al., U.S. Pat. No. 6,670,645 and Published PCT Applications WO 03/063555 and WO 2004/016710, and organometallic complexes described in, for example, Published PCT Applications WO 03/008424, WO 03/091688, and WO 03/040257, and mixtures thereof. Electroluminescent emissive layers comprising a charge carrying host material and a metal complex have been described by Thompson et al., in U.S. Pat. No. 6,303,238, and by Burrows and Thompson in published PCT applications WO 00/70655 and WO 01/41512. Examples of conjugated polymers include, but are not limited to poly(phenylenevinylenes), polyfluorenes, poly(spirobifluorenes), polythiophenes, poly(p-phenylenes), copolymers thereof, and may further include combinations or mixtures thereof.

The choice of a particular material may depend on the specific application, potentials used during operation, or other factors. The thickness of the light emitting layer is in a range of 20-200 nm. In the embodiment shown the light-emitting layer is a light emitting polymer (LEP) from one of the materials selected as described above, having a thickness of 80nm.

The cathode layer 60 is an electrode that is particularly efficient for injecting electrons or negative charge carriers. The cathode layer can be any metal or nonmetal having a lower work function than the first electrical contact layer (in this case, the anode layer). As used herein, the term "lower work function" is intended to mean a material having a work function no greater than about 4.4 eV. As used herein, "higher work function" is intended to mean a material having a work function of at least approximately 4.4 eV.

Materials for the cathode layer can be selected from alkali metals of Group 1 (e.g., Li, Na, K, Rb, Cs,), the Group 2 metals (e.g., Mg, Ca, Ba, or the like), the Group 12 metals, the lanthanides (e.g., Ce, Sm, Eu, or the like), and the actinides (e.g., Th, U, or the like). Materials such as aluminum, indium, yttrium, and combinations thereof, may also be used. Specific non-limiting examples of materials for the cathode layer include, but are not limited to, barium, lithium, cerium, cesium, europium, rubidium, yttrium, magnesium, samarium, and alloys and combinations thereof.

The cathode layer is usually formed by a chemical or physical vapor deposition process. In general, the cathode layer will be patterned, as discussed above in reference to the anode layer. If the device lies within an array, the cathode layer may be patterned into substantially parallel strips, where the lengths of the cathode layer strips extend in substantially the same direction and substantially perpendicular to the lengths of the anode layer strips. Electronic elements called pixels are formed at the cross points (where an anode layer strip intersects a cathode layer strip when the array is seen from a plan or top view). In the embodiment shown the cathode layer is formed by a combination of a first sub-layer of Ba having a thickness of 5 nm and a second sub-layer of Al having a thickness in a range of 100-400 nm, e.g. 250 nm.

Barrier layers 20, 70 may comprise any ceramic including but not limited to metal oxide, metal nitride, metal carbide, metal oxynitride, such as indium oxide (In2O3), tin oxide (SnO2), indium tin oxide (ITO) and combinations thereof. It is preferred that at at least one side of the OLED a substantially transparent ceramic is applied, including but not limited to silica or silicon oxide (SiO2), alumina or aluminum oxide (Al2O3), titania or titanium oxide (TiO2), indium oxide (In2O3), tin oxide (SnO2), indium tin oxide (ITO, In203+SnO2), aluminum nitride (AIN), silicon nitride (SiN), silicon carbide (SiC), silicon oxynitride (SiON) and combinations thereof. Instead of a barrier layer, a barrier stack may be applied. Such a stack comprises a combination of one or more inorganic layers, for example barrier layers as described above, and organic layers, which layers alternate each other in the stack.

The organic layers may comprise cross-linked (thermoset) material, an elastomer, a linear polymer, or a branched or hyper-branched polymer system or any combination of the aforementioned, optionally filled with inorganic particles of small enough size to still guarantee light transmission. The material is processed either from solution or as a 100% solids material. Curing or drying may exemplary occur by irradiation of the wet material, pure, or suitably formulated with a photo- or heat-sensitive radical or super-acid initiator, with UV-light, visible light, infrared light or heat, E-beam, grays or any combination of the aforementioned. The material of the organic layer preferably has a low specific water vapour transmission rate and a high hydrophobicity. Examples of suitable cross-linking (thermoset) systems are any single one or any combination of aliphatic or aromatic epoxy acrylates, urethane acrylates, polyester acrylates, polyether acrylates, saturated hydrocarbon acrylates, epoxides, epoxide-amine systems, epoxide-carboxylic acid combinations, oxetanes, vinyl ethers, vinyl derivatives, and thiol-ene systems. Suitable examples of elastomeric materials are polysiloxanes. Examples of suitable branched or linear polymeric systems are any single one or any copolymer or physical combination of polyacrylates, polyesters, polyethers, polypropylenes, polyethylenes, polybutadienes, polynorbornene, cyclic olefin copolymers, polyvinylidenefluoride, polyvinylidenechloride, polyvinylchloride, polytetrafluoroethylene, polychlorotrifluoroethylene, polyhexafluoropropylene. Its thickness may lay between 0.1- 100 µm, preferably between 5 - 50 µm.

It is desired to manufacture such electronic devices 1 in a mass production process. This may be realized by constructing these devices 1 on a common substrate 5 as shown in Figure 1A. Upon completion these devices are separated from each other. Usually such devices 1 are constructed as a sequence of layers.

A method according to the present invention aims to provide means for mass production, wherein in at least one stage of the manufacturing process the shape of a first functional layer determines the shape of a subsequent functional layer.

In the sequel, methods according to the invention are described with reference to various examples.

### Example 1.

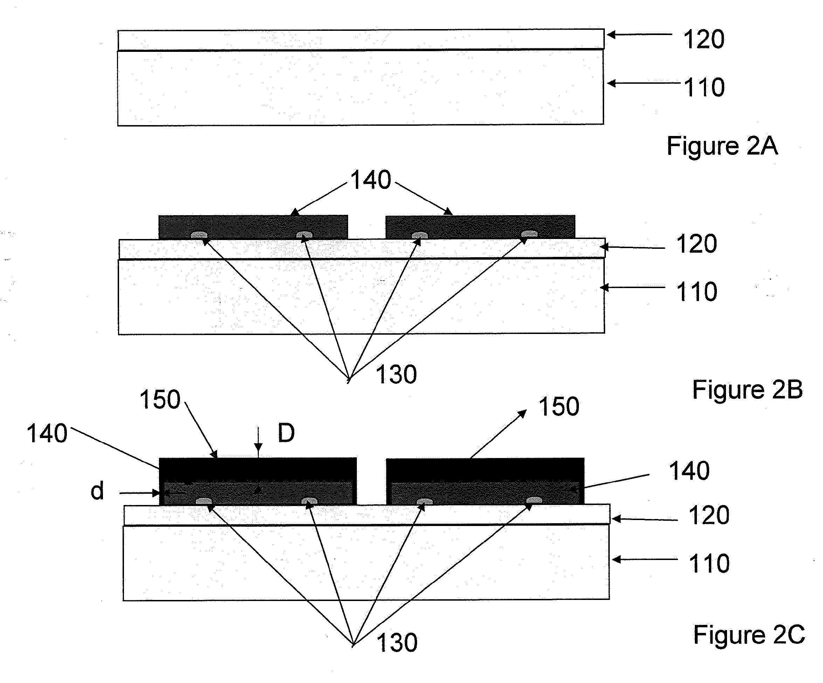

As illustrated in Figure 2A, a substrate 110 in the form of a PEN (Poly Ethylene Naphthalate) foil having a thickness of 200 µm was provided. Alternatively another polymer foil, such as PET, (Poly Ethylene Terephthalate) having a thickness in a range of for example 10 to 500 µm may be used.

Subsequently the substrate was provided with a barrier stack 120 provided with a layer of SiNx or SiO2. Such barrier stacks, comprising a stack of alternating organic and inorganic layers are known as such from US2001/0015620.

Subsequently the resulting substrate was provided with a pattern of hydrophobic and hydrophilic areas according to an atmospheric plasma treatment.

First the entire surface of the resulting substrate was rendered hydrophilic by treating it with a He/O₂ plasma during 60 s at a power of 300W. Next a pattern of hydrophobic areas was created by partially masking the surface and applying a second treatment with a He/O₂ plasma at the same power during a period of 15 s. During this second treatment the He flow was guided through a bath with hexamethyldisiloxan. The steps of the treatment are summarized in the following table.

| | He flow | O₂ flow | HMDSO(C₆H₁₈OSi₂) | Treatment time (sec) | Power (W) |
|---|---|---|---|---|---|
| hydrophiling (full area) | 80 mm 60 l/m | 20 mm 13 l/m | | 60 | 300 |
| hydrophobing (patterned) | 80 mm 60 l/m | | 110 mm He through solution ≈ 6.7x10⁻³ mol/min | 15 | 300 |

In the next step, illustrated with reference to Figure 2B, electrical connectors were applied, here in the form of busbars 130. Subsequently an anode 140 was applied of a conductive material, preferably a transparent electrically conductive material such as polyaniline, polythiophene, polypyrrole or doped polymers. Apart from organic materials, various inorganic transparent, electrically conducting materials like ITO (Indium Tin Oxide), IZO (Indium Zinc Oxide), ATO (Antimony Tin Oxide), or Tin Oxide can be used. Other metal oxides can work, including but not limited to Nickel-Tungsten-Oxide, Indium doped Zinc Oxide, Magnesium-Indium-Oxide. In this case an ITO layer having a thickness of 100 nm was applied as the patterned first functional layer.

In a subsequent step a pattern of PEDOT:PSS forming a hole transport layer was applied as the second functional layer 150. The PEDOT:PSS or Poly(3,4-ethylenedioxythiophene) poly(styrenesulfonate) is a polymer mixture of two ionomers. The compound is applied as a dispersion of gelled particles in water. This dispersion has a surface tension of 70 mN/m. The coating layer may be dried before further processing. The dried PEDOT:PSS layer had a resulting thickness in the range of 50 to 200 nm, in this case 100 nm and a surface energy of 44mN/m.

As the dispersion used to apply the second functional layer has a surface tension ST3 in the range of SU1 in the areas left free by the first functional layer, and the SU2 in the areas occupied by the first functional layer, the liquid substance used for the second functional layer assumes the shape of the pattern formed in the first functional layer.

As can be seen in Figure 2C, the second functional layer 150 has a thickness D of 100 nm, and covers the first functional layer 140. The second functional layer 150 covers the side surfaces of the first functional layer 140. Therewith the second functional layer 150 is bounded laterally at a distance d from the side surfaces of the first functional layer. As is shown, the distance d has a value smaller than 2D.

The product may be finished in a manner known as such for organic electronic products. To obtain an OLED, subsequently a luminescent layer and a cathode layer is applied. Finally the product is protected by a barrier layer to prevent moisture from causing damage. In particular the cathode layer and the luminescent layer may be vulnerable to water.

### Example 2

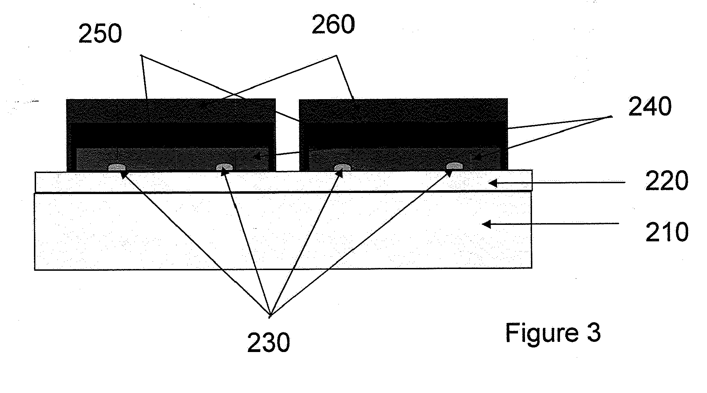

In an attractive embodiment the semi-finished product obtained with example 1 may be finished according to a method according to the invention as described in the following example, with reference to Figure 3. Alternatively the steps described in example 2 may be applied to a semi-finished product obtained in a conventional manner. In Figure 3, parts corresponding to those in Figures 2A, 2B have a reference number that is 100 higher. In this second example the hole transport layer 250 is considered as the patterned first functional layer.

A further coating with a solution of a light emitting polymer LEP (e.g. fluorine arylamine copolymer) into a mixture of methyl benzoate and mesithylene in the ratio 4:1 is applied on the modified substrate coated with the, patterned first layer. This solution has a surface tension with a value ST2. This is in a range of SU1 < ST2 < SU3, wherein SU3 is the surface energy of the first functional layer 250.

As the liquid substance applied to form the second functional layer has a surface tension higher than that of the modified substrate, but lower than that of first functional layer, the liquid substance withdraws from the substrate and forms a second functional layer at the first surface of the first functional layer that is remote from the substrate and at the side surfaces of the first functional layer adjoining the first surface. Therewith the second functional layer is bounded laterally at a distance of at most 2D from the side surfaces of the first functional layer, wherein D is the thickness of the second functional layer on the first functional layer. One or more further layers of LEP may be applied on this functional layer in a way analogously to which this second functional layer (the first layer of LEP) was applied on the first functional layer. The first functional layer may be dried to obtain the surface tension of the solids or contain still an amount of solvent. In the latter case the surface tension of the first layer will be a result of the surface tension of the solids and the solvent. This is described in example 3.

### Example 3.

A second and a third functional layer are applied simultaneously at the first functional layer. In particular the second and the third functional layer are applied as solutions of LEP1 and LEP2 into a mixture of methyl benzoate and mesithylene. The multi layer has a surface tension with a value ST2. This is in a range of SU1 < ST4 < SU3,) wherein SU3 is the surface energy of the first functional layer. Here, the first functional layer is the hole transporting layer 250. Alternatively, the first functional layer may be an already deposited light emitting layer 260 with a surface energy SU4.

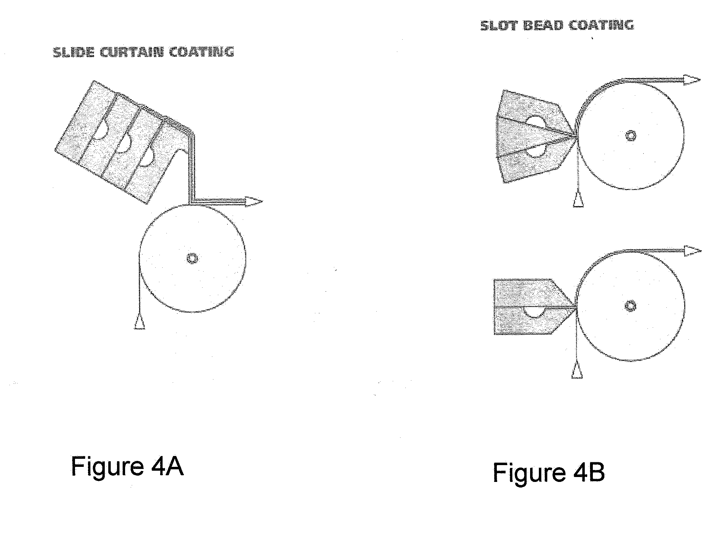

The layers of the multilayer coating may be applied simultaneously by using slide curtain coating or slot bead coating as illustrated in Figure 4A and 4B for example.

As the liquid substance used to apply the second functional layer has a surface tension higher than that of the modified substrate, but lower than that of the first functional layer 260, the liquid substance withdraws from the substrate and forms a second functional layer at the surface of the first functional layer that is remote from the substrate and at the side surfaces of the first functional layer adjoining the first surface. Therewith the second functional layer is bounded laterally at a distance of at most 2D from the side surfaces of the first functional layer, wherein D is the thickness of the second functional layer on the first functional layer In this embodiment the second and the third layer that are applied simultaneously are functional layers that have substantially the same function, here both light emitting layers, albeit that the layers differ in workfunction. Alternatively, layers having a different function may be applied simultaneously, such as a light emitting layer and an electron transporting layer for example. Alternatively a larger plurality than two, e.g. five or ten layers may be applied simultaneously at the first functional layer.

### Example 4.

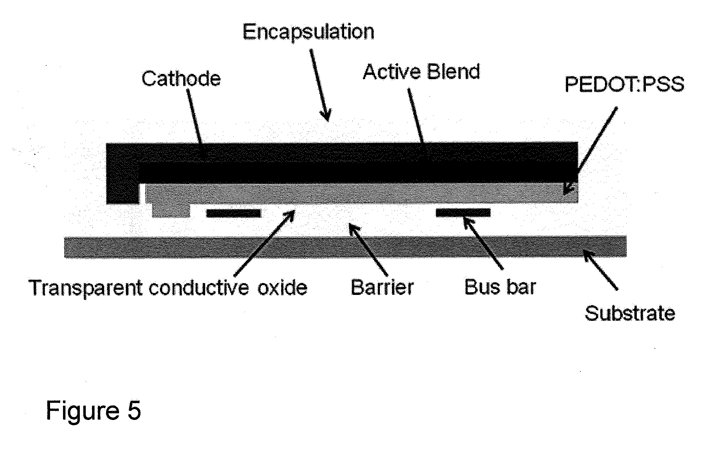

In this example the method according to the invention is applied for manufacturing a solar cell as shown in Figure 5. The solar cell has functional layers formed by a transparent conductive anode, a hole transporting layer (e.g. PEDOT:PSS), an active layer e.g. composed of poly(3-hexylthiophene) and a fullerene derivate (e.g. P3HT(poly(3-hexylthiophene)) in a P3HT/PCBM layer and a cathode. The stack formed by these functional layers is encapsulated by barrier layers and provided on a substrate.

In this example the hole transporting layer is considered as the first functional layer and as a second functional layer, a second solution of P3HT/PCBM in dichlorobenzene is applied on the modified substrate coated with said patterned first functional layer. The liquid substance formed by this second solution has a surface tension with a value ST5. This is in a range of SU1 < ST5 <SU5, wherein SU1 is the surface energy of the substrate and SU5 is the surface energy of the areas occupied by the first functional layer.

As the liquid substance has a surface tension higher than that of the modified substrate, but lower than that of first functional layer, the second solution withdraws from the substrate and forms a second layer at the first surface of the first layer that is remote from the substrate and at the side surfaces of the first layer adjoining the first surface. Therewith the second functional layer is bounded laterally at a distance of at most 2D from the side surfaces of the first functional layer, wherein D is the thickness of the second functional layer on the first functional layer.

### Example 5.

When manufacturing a solar cell as shown in Figure 5, also a multilayer coating may be applied to form the light sensitive layer. In this example a second and a third functional layer are applied simultaneously at the first functional layer. In particular the second and the third layer are solutions of P3HT1/PCBM and P3HT2/PCBM respectively in dichlorobenzene for the active blend. The solutions having substantially equal values for the surface tension ST7a,b are applied on the modified substrate coated with the patterned first functional layer formed by the hole transport layer. This is in a range of SU1 < ST7a,b < SU5, wherein SU5 is the surface energy of the first layer. As the solutions have a surface tension higher than that of the modified substrate, but lower than that of the first functional layer, the stack of solutions withdraws from the substrate and forms a stack of functional layers at the surface of the first functional layer that is remote from the substrate and at the side surfaces of the first functional layer adjoining the first surface. Therewith the stack of functional layers is bounded laterally at a distance of at most 2D from the side surfaces of the first functional layer, wherein D is the thickness of the stack on the first functional layer.

As used herein, the terms "comprises," "comprising," "includes," "including," "has," "having" or any other variation thereof, are intended to cover a non-exclusive inclusion. For example, a process, method, article, or apparatus that comprises a list of elements is not necessarily limited to only those elements but may include other elements not expressly listed or inherent to such process, method, article, or apparatus. Further, unless expressly stated to the contrary, "or" refers to an inclusive or and not to an exclusive or. For example, a condition A or B is satisfied by any one of the following: A is true (or present) and B is false (or not present), A is false (or not present) and B is true (or present), and both A and B are true (or present).

Also, use of the "a" or "an" are employed to describe elements and components of the invention. This is done merely for convenience and to give a general sense of the invention. This description should be read to include one or at least one and the singular also includes the plural unless it is obvious that it is meant otherwise. Unless otherwise defined, all technical and scientific terms used herein have the same meaning as commonly understood by one of ordinary skill in the art to which this invention belongs. Although methods and materials similar or equivalent to those described herein can be used in the practice or testing of the present invention, suitable methods and materials are described below. All publications, patent applications, patents, and other references mentioned herein are incorporated by reference in their entirety. In case of conflict, the present specification, including definitions, will control.

## Claims

1. Method of manufacturing an electronic device comprising a sequence of functional layers, comprising the steps of
- providing a substrate
- providing a patterned first functional layer of a first substance on the substrate, resulting in at least one first area covered by the first substance having a surface tension or surface energy SUn and at least one second area not covered by the first substance having a surface tension or surface energy SUm,
- applying a second functional layer as a liquid substance, the liquid substance having a surface tension STk in the range of SUm < STk ≤ SUn.

2. Method according to claim 1, **characterized by** the additional step of drying the first functional layer before the second functional layer is applied.

3. Method according to claim 1, **characterized in that** the second functional layer is applied before the first functional layer is dried.

4. Method according to claim 1, **characterized in that** at least a third functional layer is applied simultaneously with the second functional layer at the first functional layer.

5. Method of manufacturing an electronic device according to one of the previous claims, **characterized in that** the first substance is an electrically conductive material.

6. Method of manufacturing an electronic device according to one of the previous claims, **characterized by** separating a stack of functional layers formed upon said at least one area from a remaining portion of a semi-finished product using the previous steps.

7. Method according to claim 6, **characterized in that** the substrate is removed from said stack of functional layers after the step of separating.

8. Electronic device comprising:
- a substrate,
- a first functional layer having a first surface remote from the substrate and side surfaces adjoining the first surface,
- a second functional layer having a thickness D that covers the first functional layer, **characterized in that** the second functional layer covers the side surfaces of the first functional layer, the second functional layer being bounded laterally at a distance of at most 2D from the side surfaces of the first functional layer.
